# FASCICULE DE BREVET EUROPEEN

(11) **EP 4 124 188 B1**
(45) Date de publication et mention de la délivrance du brevet: **15.04.2026**
(21) Numéro de dépôt: 22186393.9
(22) Date de dépôt: 22.07.2022
(51) Int. Cl.: H05K 5/02

(54) **MONTAGE D'UN INTERRUPTEUR DE SÉCURITÉ**
MONTAGE EINES SICHERHEITSTRENNSCHALTERS
MOUNTING OF A SAFETY SWITCH

(30) Priorité: 22.07.2021 FR 2107896
(43) Date de publication de la demande: 25.01.2023
(73) Titulaire: THALES, 92190 Meudon (FR)
(72) Inventeur: DUCOIN, Damien, 49309 Cholet (FR); ABELLARD, Simon, 49309 Cholet (FR); BOUSQUET, Olivier, 49309 Cholet (FR)
(74) Mandataire: Atout PI Laplace

(56) Documents cités:
- DE-A1- 102013 221 853
- FR-A1- 2 911 702

## Description

De nombreux équipements électroniques sont équipés de moyens permettant de détecter une intrusion. Les documents DE 10 2013 21853 A1 et FR 2 911 702 A1 décrivent des boîtier munis d'interrupteurs permettant de détecter l'ouverture d'un couvercle du oîtier. L'invention s'intéresse à la détection d'une intrusion physique. Plus précisément, l'invention propose un moyen d'informer en cas d'ouverture d'un équipement.

Cette fonction de détection d'ouverture peut être réalisée au moyen d'un interrupteur disposé entre un boîtier et un capot assurant la fermeture du boîtier. L'ouverture du capot entraine une manœuvre de l'interrupteur. La détection d'ouverture est assurée par un circuit électronique relié à l'interrupteur.

La détection d'ouverture souffre cependant de faiblesses et de fausses détections d'ouverture peuvent apparaitre. Le circuit électronique peut être la cause de ces fausses détections. Une autre cause réside dans le montage mécanique de l'interrupteur.

Plus précisément, pour être au plus près du circuit électronique configuré pour détecter l'ouverture, le corps de l'interrupteur est généralement monté sur un circuit imprimé solidaire du boitier. La partie mobile de l'interrupteur est en contact avec le capot. Lors d'une ouverture du capot la partie mobile de l'interrupteur se déplace et l'interrupteur change d'état. L'interrupteur peut passer d'un état fermé à un état ouvert ou inversement lors de l'ouverture du capot.

La chaîne de cotes définissant la position de la partie mobile de l'interrupteur par rapport à sa partie fixe peut comprendre un grand nombre de cotes, chacune associée à une pièce mécanique, notamment, la partie fixe de l'interrupteur, le circuit imprimé sur lequel est monté l'interrupteur, des entretoises portant le circuit imprimé, le boîtier portant les entretoises, et enfin le capot fixé sur le boîtier et sur lequel s'appuie la partie mobile de l'interrupteur. Le grand nombre de pièces mécaniques entrant dans cette chaîne de cotes peut entrainer une imprécision dans la manœuvre de l'interrupteur. D'un équipement à l'autre, même si chacune les pièces mécaniques sont fabriquées correctement, c'est-à-dire que les cotes sont réalisées toutes dans leur intervalle de tolérance respectif, une dispersion importante peut intervenir dans la position de la partie mobile de l'interrupteur par rapport à sa partie fixe. Même si au montage de l'équipement, l'interrupteur participe normalement à la fonction de détection d'ouverture, il est possible que la position de la partie mobile de l'interrupteur par rapport à sa partie fixe soit proche de l'état inverse de l'interrupteur. Durant l'utilisation de l'équipement, des chocs ou des vibrations peuvent alors déclencher de façon inappropriée un changement d'état de l'interrupteur. Ce type de situation n'est malheureusement pas détectable lors d'opérations de contrôle après la fabrication de l'équipement.

Pour pallier certaines dispersions dans l'assemblage mécanique, il est possible de prévoir un réglage de position de certaines pièces entrant dans l'assemblage. Ce type de solution est couteux et pas toujours bien reproductible.

L'invention vise à rendre plus robuste la détection d'ouverture d'un équipement. Plus généralement l'invention propose de simplifier le montage d'un interrupteur de sécurité afin de lui permettre de remplir sa fonction de façon plus sûre.

A cet effet, l'invention a pour objet un équipement électronique comprenant un boîtier, un capot fermant le boîtier, un circuit électronique disposé dans le boîtier et un interrupteur de sécurité configuré pour détecter une ouverture du capot, l'interrupteur de sécurité étant fixé sur un circuit imprimé souple raccordant l'interrupteur de sécurité au circuit électronique, le circuit imprimé souple étant fixé au boîtier en regard de l'interrupteur de sécurité, dans lequel l'interrupteur de sécurité comprend une partie fixe fixée sur le circuit imprimé souple et une partie mobile prenant appui contre une face du capot, et dans lequel :
- soit la face du capot vient au contact du boîtier,
- soit le circuit imprimé souple est fixé sur une face du boitier, la face du boitier venant au contact du capot.

Avantageusement, l'interrupteur de sécurité est positionné sur le circuit imprimé souple directement et sans intermédiaire et est fixé au moyen de brasures permettant d'assurer le raccordement électrique de l'interrupteur de sécurité sur le circuit imprimé souple.

Le circuit imprimé souple peut comprendre une couche de blindage électrique interrompue au niveau du raccordement et de la fixation de l'interrupteur sur le circuit imprimé souple.

L'invention a également pour objet un procédé de fabrication d'un équipement électronique selon l'invention, dans lequel le boîtier comprend une première face sur laquelle est fixée le circuit imprimé souple et une seconde face sur laquelle le capot prend appui, et dans lequel une cote séparant la première face de la seconde face est une cote directe de fabrication.

L'invention a encore pour objet un procédé de fabrication d'un équipement électronique selon l'invention, dans lequel le capot comprend une première face sur laquelle une partie mobile de l'interrupteur de sécurité prend appui et une seconde face prenant appui sur le boîtier, et dans lequel une cote séparant la première face de la seconde face est une cote directe de fabrication.

L'invention sera mieux comprise et d'autres avantages apparaîtront à la lecture de la description détaillée d'un mode de réalisation donné à titre d'exemple, description illustrée par le dessin joint dans lequel :
la figure 1 représente une variante d'un équipement électronique conforme à l'invention ;
la figure 2 représente une chaîne de cotes de la variante de la figure 1 ;
la figure 3 représente une autre variante d'un équipement électronique conforme à l'invention ;
la figure 4 représente un exemple de circuit imprimé souple mis en œuvre dans les variantes des figures 1 et 3.

Par souci de clarté, les mêmes éléments porteront les mêmes repères dans les différentes figures.

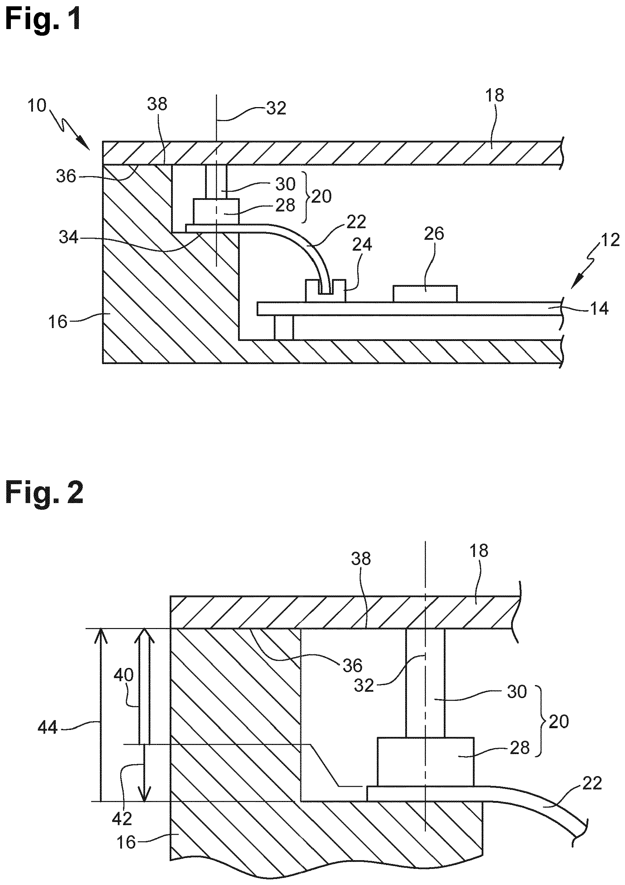

La figure 1 représente un équipement électronique 10 en coupe partielle. La fonction principale de l'équipement électronique 10 est assurée par un circuit électronique 12, par exemple porté par un circuit imprimé 14. Le circuit électronique 12 est disposé dans un boîtier 16 fermé par un capot 18. L'équipement électronique 10 comprend également de moyens permettant de détecter une intrusion physique et plus précisément une ouverture du capot 18. De façon plus générale, les appellations boîtier et capot ne sont données qu'à titre d'exemple pour mieux illustrer l'invention. Dans la pratique, il peut s'agir de deux pièces mécaniques distinctes de l'équipement électronique 10 fixées l'une à l'autre et pour lequel on souhaite obtenir une information concernant la désolidarisation.

Les moyens permettant de détecter une ouverture du capot 18 comprennent un interrupteur 20 disposé entre le boîtier 16 et le capot 18. Lorsque le capot 18 est fixé sur le boîtier 16, l'interrupteur 20 est dans un premier état et lorsque le capot 18 est à distance du boîtier 16, l'interrupteur 20 est dans un second état. Le premier état peut être un état fermé et le second : ouvert. L'inverse est également possible. L'interrupteur 20 est relié électriquement au circuit électronique 12 qui traite l'information reçue de l'interrupteur 20 pour informer sur une désolidarisation du capot 18.

L'interrupteur 20 n'est pas fixé au boîtier 16 par l'intermédiaire du circuit électronique 12. Selon l'invention, l'interrupteur 20 est fixé sur un circuit imprimé souple 22 raccordant électriquement l'interrupteur 20 au circuit électronique12 et le circuit imprimé souple 22 est fixé au boîtier 16 en regard de l'interrupteur 20. Autrement dit, le circuit imprimé souple 22 et l'interrupteur 20 sont empilés sur le boitier 16. La fonction du circuit imprimé souple 22 est le raccordement électrique de l'interrupteur 20 au circuit électronique12. L'interrupteur 20 est fixé à une première extrémité du circuit imprimé souple 22 et la seconde extrémité du circuit imprimé souple 22 est raccordée au circuit électronique12, par exemple au moyen d'un connecteur 24 solidaire du circuit imprimé 14 et assurant le raccordement vers un module de traitement 26 du signal reçu de l'interrupteur 20 et appartenant au circuit électronique12.

Seuls des moyens de fixation de type film adhésif d'épaisseur calibrée peuvent être intercalés entre l'interrupteur 20 et le circuit imprimé souple 22 et/ou entre le boîtier 16 et le circuit imprimé souple 22.

L'interrupteur 20 comprend un socle 28 formant la partie fixe de l'interrupteur et un poussoir 30 formant la partie mobile de l'interrupteur 20. Le déplacement du poussoir 30 par rapport au socle 28 permet à l'interrupteur 20 de changer d'état. Lorsque le capot 18 est fixé au boîtier 16, le poussoir 30 est dans une position dite rentrée dans le socle 28 et lorsque le capot 18 est désolidarisée du boîtier 16, le poussoir 30 est dans une position dite sortie par rapport au socle 28. L'interrupteur 20 pris isolément ne possède qu'une seule position stable correspondant à sa position sortie. Implanté dans l'équipement électronique 10, l'interrupteur 20 est dans sa position rentrée lorsque le capot 18 est fixé au boîtier 16 et passe automatiquement dans sa position sortie lorsque le capot 18 est désolidarisé du boîtier 16.

Dans l'exemple représenté, le déplacement du poussoir 30 par rapport au socle 28 se fait en translation selon un axe 32, vertical sur la figure 1. Il est également possible de prévoir un interrupteur dont la partie mobile pivote par rapport à la partie fixe.

Dans la variante de la figure 1, le circuit imprimé souple 22 est fixé sur une première face 34 du boîtier 16 perpendiculaire à l'axe 32. Par ailleurs, le capot 18 est positionné et fixé sur une seconde face 36 du boîtier 16. La face 36 est également perpendiculaire à l'axe 32. Sur la figure 1 seul le positionnement vertical du capot 18 par rapport au boîtier 16 est représenté. Le positionnement latéral du capot 18 par rapport au boîtier 16 peut être assuré par exemple par des vis, non représentées, et assurant également la fixation du capot 18 sur le boîtier 16. Le capot 18 comprend une face 38 prenant appui contre la face 36 du boîtier 16. Il est possible d'utiliser une autre face du capot 18 pour assurer le contact avec le poussoir 30 de l'interrupteur 20. Alternativement pour simplifier la chaîne de cotes, le poussoir 30 prend également appui contre la face 38 lorsque le capot 18 ferme le boîtier 16. Avantageusement, la face 38 est plane, ce qui simplifie sa réalisation.

Plus précisément, la chaîne de cotes assurant le bon fonctionnement de l'interrupteur est représenté sur la figure 2. L'intervalle de tolérance sur la cote condition 40 assurant le bon fonctionnement de l'interrupteur 20 n'est égal qu'à la somme des intervalles de tolérance de deux cotes fonctionnelles, l'intervalle de tolérance d'une cote 42 définissant l'épaisseur du circuit imprimé souple 22, intégrant éventuellement un ou deux films autocollants d'épaisseur calibrée, et l'intervalle de tolérance d'une cote 44 définissant la distance séparant les faces 34 et 36 du boîtier 16. Lorsque la face 38 du capot 18 sert d'appui à la fois pour le boîtier 16 et pour le poussoir 30 de l'interrupteur 20, la chaîne de cotes ne contient aucune cote du capot 18.

Dans un procédé de fabrication particulièrement avantageux, la cote 44 séparant les faces 34 et 36 est une cote directe de fabrication. Cette cote peut être obtenue par usinage. Plus précisément, l'ébauche du boîtier 16 peut être réalisée par tout autre moyen de fabrication, par exemple par moulage. Après réalisation de l'ébauche, plusieurs faces du boîtier 16 sont reprises par usinage pour les amener à respecter des tolérances dimensionnelles, de forme et de position permettant à ces faces de remplir leur fonction. La face 36 doit notamment respecter une tolérance de planéité afin de recevoir le capot 18. La face 34 doit également respecter une tolérance de forme pour recevoir le circuit imprimé souple 22 et de position afin d'assurer la bonne orientation de l'axe 32. Il est possible de réduire l'intervalle de tolérance dimensionnel de la cote 44 séparant les faces 34 et 36 en usinant les deux faces lors d'une même phase de fabrication, c'est-à-dire au moyen de la même machine d'usinage et sans modification de la fixation de la pièce à usiner sur un plateau de la machine prévu pour la recevoir. Autrement dit, lors de cette phase de fabrication, seul le déplacement de l'outil d'usinage par rapport à la pièce, entre la réalisation des deux faces 34 et 36, est à prendre en compte dans la tolérance de fabrication.

Dans la variante de la figure 1, pour le capot 18, une même face : la face 38 est utilisée pour réaliser à la fois l'appui contre le boîtier 16 et comme surface d'appui du poussoir 30 de l'interrupteur 20.

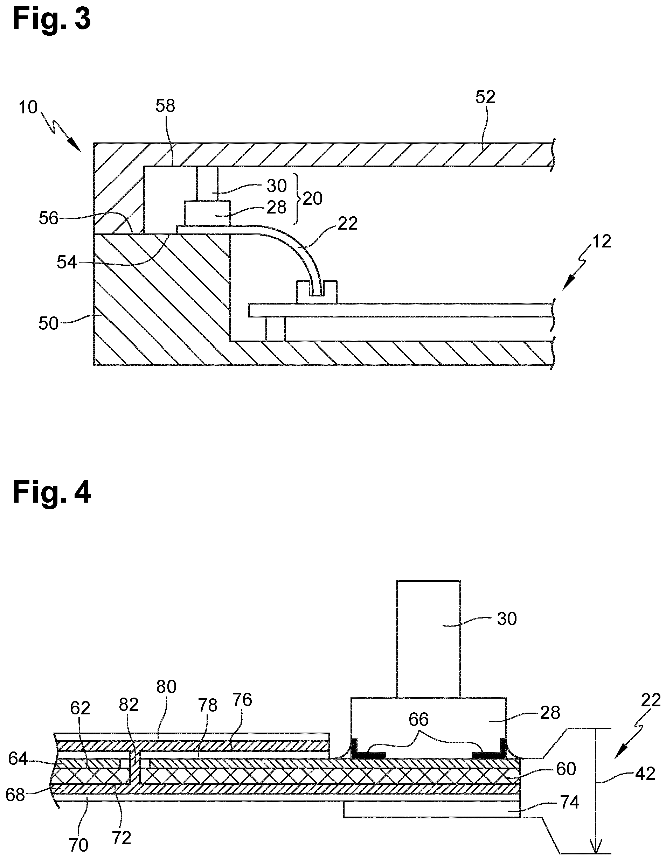

La figure 3 représente une seconde variante de l'équipement électronique 10 dans lequel le boitier porte la référence 50 et le capot la référence 52. On y retrouve le circuit électronique 12, l'interrupteur 20 et le circuit imprimé souple 22. A la différence de la première variante représentée sur la figure 1, le boîtier 50 comprend une face 54 utilisée pour porter le circuit imprimé souple 22 et l'interrupteur 20. La face 54 est également utilisée comme surface d'appui du capot 52. Avantageusement, la face 54 est plane, ce qui simplifie sa réalisation. Concernant le capot 52, dans cette variante, il comprend deux faces distinctes : l'une 56 prenant appui contre la face 54 du boîtier 50 et l'autre 58 sur laquelle le poussoir 30 prend appui. La chaîne de cotes de la seconde variante peut se déduire de celle de la première variante. A l'image de la chaîne de cote représentée sur la figure 2, la chaîne de cote de la variante représentée sur la figure 3 est très simple. Plus précisément, lorsque la face 54 du boîtier 50 sert d'appui à la fois pour le capot 52 et pour le circuit imprimé souple 22, la chaîne de cotes ne contient aucune cote du boîtier 50. Les deux chaînes de cotes ne comprennent que deux cotes fonctionnelles permettant de refermer la cote condition de l'interrupteur 20.

La figure 4 représente en coupe l'extrémité du circuit imprimé souple 22 portant l'interrupteur 20. Le circuit imprimé souple 22 comprend un substrat souple isolant 60. Le substrat souple isolant 60 peut être formé à base de différents matériaux plastiques souples tels que par exemple du polycarbonate ou du polyimide. Sur une des faces du substrat 60, la face supérieure 62 sur la figure 4, sont gravées des pistes 64 permettant le raccordement de l'interrupteur 20. Les contacts électriques 66 de l'interrupteur 20 sont raccordés électriquement aux pistes 64. Le raccordement peut être réalisé par brasage assurant également la fixation du socle 28 sur le circuit imprimé souple 22. Comme évoqué plus haut, l'utilisation du raccordement électrique pour assurer le maintien mécanique de l'interrupteur 20 permet de se positionner le socle 28 directement et sans intermédiaire sur le circuit imprimé souple 22, ce qui simplifie la chaîne de cotes décrite plus haut.

Les signaux électriques transitant entre l'interrupteur 20 et le circuit électronique 12 peuvent nécessiter une protection par blindage au moyen d'un plan conducteur, par exemple relié à une masse électrique du circuit électronique 12. A cet effet, une couche de blindage électrique 68 et une couche isolante 70 peuvent être disposées sur la face inférieure 72 du substrat souple isolant 60. La couche de blindage électrique 68 est alors disposée le long du circuit imprimé souple 22 entre le du circuit électronique 12 et l'interrupteur 20. La couche de blindage électrique 68 peut être interrompue au niveau de l'interrupteur 20 ou être prolongée sous celui-ci comme représenté sur la figure 4. Par ailleurs, le maintien mécanique du circuit imprimé souple 22 sur le boîtier 16 ou 50 peut être assuré au moyen d'un film adhésif 74 d'épaisseur calibrée disposé sous le substrat souple isolant 60 ou sous la couche isolante 70 lorsqu'elle est présente en association avec la couche de blindage électrique 68. La cote 42 définissant l'épaisseur du circuit imprimé souple 22 comprend donc au moins les pistes 64 et le substrat souple isolant 60. Optionnellement dans la cote 42 peuvent être intégrés la couche de blindage électrique 68, la couche isolante 70 et le film adhésif 74.

La couche de blindage électrique 68 est prévue sur la face 72 du substrat souple isolant 60. Alternativement, ou en complément, Il est possible de prévoir une autre couche de blindage électrique 76 disposée au-dessus des pistes 64 avec une couche d'isolant électrique 78 séparant la couche de blindage électrique 76 des pistes 64. Une couche isolante 80 semblable à la couche 70 peut recouvrir la couche de blindage électrique 76. Si les deux couches de blindage électriques 68 et 76 sont prévues, il est possible de les raccorder électriquement au moyen d'un via métallisé 82 traversant la couche d'isolant électrique 78, les pistes 64 et le substrat souple isolant 60.

La couche de blindage 76 présente l'intérêt de pouvoir être interrompue au niveau du raccordement et de la fixation du socle 28 sur le circuit imprimé souple 22. Ainsi le complément d'épaisseur du circuit imprimé souple 22 dû à la couche de blindage électrique 76 n'entre pas dans la cote 42.

## Revendications

1. Equipement électronique comprenant un boîtier (16 ; 50), un capot (18 ; 52) fermant le boîtier (16 ; 50), un circuit électronique (12) disposé dans le boîtier (16 ; 50) et un interrupteur de sécurité (20) configuré pour détecter une ouverture du capot (18 ; 52), l'interrupteur de sécurité (20) étant fixé sur un circuit imprimé souple (22) raccordant l'interrupteur de sécurité (20) au circuit électronique (12), le circuit imprimé souple (22) étant fixé au boîtier (16 ; 50) en regard de l'interrupteur de sécurité (20), dans lequel l'interrupteur de sécurité (20) comprend une partie fixe (28) fixée sur le circuit imprimé souple (22) et une partie mobile (30) prenant appui contre une face (38) du capot (18), et dans lequel :
- soit la face (38) du capot (18) vient au contact du boîtier (16),
- soit le circuit imprimé souple (22) est fixé sur une face (54) du boitier (50), la face (54) du boitier (50) venant au contact du capot (52).

2. Equipement électronique selon la revendication 1, dans lequel l'interrupteur de sécurité (20) est positionné sur le circuit imprimé souple (22) directement et sans intermédiaire et est fixé au moyen de brasures permettant d'assurer le raccordement électrique de l'interrupteur de sécurité (20) sur le circuit imprimé souple (22).

3. Equipement électronique selon l'une des revendications précédentes, dans lequel le circuit imprimé souple (22) comprend une couche de blindage électrique (76) interrompue au niveau du raccordement et de la fixation de l'interrupteur (20) sur le circuit imprimé souple (22).

4. Procédé de fabrication d'un équipement électronique selon l'une des revendications précédentes, dans lequel le boîtier (16) comprend une première face (34) sur laquelle est fixée le circuit imprimé souple (22) et une seconde face (36) sur laquelle le capot (38) prend appui, et dans lequel une cote (44) séparant la première face (34) de la seconde face (36) est une cote directe de fabrication.

5. Procédé de fabrication d'un équipement électronique selon l'une des revendications 1 à 3, dans lequel le capot (52) comprend une première face (58) sur laquelle une partie mobile (30) de l'interrupteur de sécurité (20) prend appui et une seconde face (56) prenant appui sur le boîtier (50), et dans lequel une cote séparant la première face (58) de la seconde face (56) est une cote directe de fabrication.

## Patentansprüche

1. Elektronische Einrichtung, umfassend ein Gehäuse (16; 50), eine Abdeckung (18; 52), die das Gehäuse (16; 50) verschließt, eine in dem Gehäuse (16; 50) angeordnete elektronische Schaltung (12) und einen Sicherheitsschalter (20), der zum Detektieren eines Öffnens der Abdeckung (18; 52) konfiguriert ist, wobei der Sicherheitsschalter (20) auf einer flexiblen Leiterplatte (22) befestigt ist, die den Sicherheitsschalter (20) mit der elektronischen Schaltung (12) verbindet, wobei die flexible Leiterplatte (22) an dem Gehäuse (16; 50) gegenüber dem Sicherheitsschalter (20) befestigt ist, wobei der Sicherheitsschalter (20) ein festes Teil (28), das an der flexiblen Leiterplatte (22) befestigt ist, und ein bewegliches Teil (30) umfasst, das gegen eine Fläche (38) der Abdeckung (18) anliegt, und wobei:
- entweder die Fläche (38) der Abdeckung (18) mit dem Gehäuse (16) in Kontakt kommt,
- oder die flexible Leiterplatte (22) an der Fläche (54) des Gehäuses (50), der Fläche (54) des Gehäuses (50), die mit der Abdeckung (52) in Kontakt kommt, befestigt ist.

2. Elektronische Einrichtung nach Anspruch 1, wobei der Sicherheitsschalter (20) direkt und unmittelbar an der flexiblen Leiterplatte (22) positioniert ist und mittels Lötstellen befestigt ist, die erlauben, die elektrische Verbindung des Sicherheitsschalters (20) auf der flexiblen Leiterplatte (22) zu gewährleisten.

3. Elektronische Einrichtung nach einem der vorstehenden Ansprüche, wobei die flexible Leiterplatte (22) eine Schicht zur elektrischen Abschirmung (76) umfasst, die auf Höhe der Verbindung und der Befestigung des Schalters (20) auf der flexiblen Leiterplatte (22) unterbrochen ist.

4. Verfahren zur Herstellung einer elektronischen Einrichtung nach einem der vorstehenden Ansprüche, wobei das Gehäuse (16) eine erste Fläche (34), auf der die flexible Leiterplatte (22) befestigt ist, und eine zweite Fläche (36) umfasst, auf der die Abdeckung anliegt, und wobei eine Dimension (44), die die erste Fläche (34) von der zweiten Fläche (36) trennt, eine direkte Dimension der Herstellung ist.

5. Verfahren zur Herstellung einer elektronischen Einrichtung nach einem der Ansprüche 1 bis 3, wobei die Abdeckung (52) eine erste Fläche (58), auf der ein bewegliches Teil (30) des Sicherheitsschalters (20) anliegt, und eine zweite Fläche (56) umfasst, die auf dem Gehäuse (50) anliegt, und wobei eine Dimension, die die erste Fläche (58) von der zweiten Fläche (56) trennt, eine direkte Dimension der Herstellung ist.

## Claims

1. Electronic equipment item comprising a housing (16; 50), a cover (18; 52) which closes the housing (16; 50), an electronic circuit (12) which is arranged in the housing (16; 50) and a safety switch (20) which is configured to detect an opening of the cover (18; 52), the safety switch (20) being fixed to a flexible printed circuit board (22) which connects the safety switch (20) to the electronic circuit (12), the flexible printed circuit board (22) being fixed to the housing (16; 50) opposite the safety switch (20), wherein the safety switch (20) comprises a fixed portion (28) which is fixed to the flexible printed circuit board (22) and a movable portion (30) which bears against a face (38) of the cover (18), and wherein
- either the face (38) of the cover (18) comes into contact with the housing (16),
- or the flexible printed circuit board (22) is fixed to a face (54) of the housing (50), the face (54) of the housing (50) coming into contact with the cover (52).

2. Electronic equipment item according to claim 1, wherein the safety switch (20) is positioned on the flexible printed circuit board (22) directly and without any intermediary and is fixed by means of brazes which enable the electrical connection of the safety switch (20) to the flexible printed circuit board (22) to be ensured.

3. Electronic equipment item according to either of the preceding claims, wherein the flexible printed circuit board (22) comprises an electrical shielding layer (76) which is interrupted in the region of the connection and the fixing of the switch (20) to the flexible printed circuit board (22).

4. Method for manufacturing an electronic equipment item according to any one of preceding claims, wherein the housing (16) comprises a first face (34) to which the flexible printed circuit board (22) is fixed and a second face (36) on which the cover (38) is supported, and wherein a dimension (44) which separates the first face (34) from the second face (36) is a direct manufacturing dimension.

5. Method for manufacturing an electronic equipment item according to any one of claims 1 to 3, wherein the cover (52) comprises a first face (58) on which a movable portion (30) of the safety switch (20) is supported and a second face (56) which bears on the housing (50) and wherein a dimension which separates the first face (58) from the second face (56) is a direct manufacturing dimension.
